# EUROPEAN PATENT SPECIFICATION

(11) **EP 3 907 737 B1**
(45) Date of publication and mention of the grant of the patent: **21.08.2024**
(21) Application number: 21166023.8
(22) Date of filing: 30.03.2021
(51) Int. Cl.: G11C 7/08, G11C 7/06, G11C 11/419

(54) **TIME-INTERLEAVING SENSING SCHEME FOR PSEUDO DUAL-PORT MEMORY**
ZEITVERSCHACHTELTES ABTASTSCHEMA FÜR PSEUDO-DUAL-PORT-SPEICHER
SCHÉMA DE DÉTECTION D'ENTRELAÇAGE TEMPOREL POUR PSEUDO-MÉMOIRE DOUBLE PORT

(30) Priority: 16.04.2020 US 202063010715 P; 24.03.2021 US 202117210521
(43) Date of publication of application: 10.11.2021
(60) Divisional application: 22184718.9
(73) Proprietor: MediaTek Inc., Hsin-Chu 300 (TW)
(72) Inventor: KUO, Yi-Ping, Hsinchu City 30078 (TW); CHIU, Yi-Te, Hsinchu City 30078 (TW)
(74) Representative: Haseltine Lake Kempner LLP

(56) References cited:
- JP-B2- 4 673 008
- US-A1- 2008 181 040
- US-A1- 2009 129 173
- US-B2- 10 026 472
- ISHII YUICHIRO ET AL: "A 5.92-Mb/mm2 28-nm pseudo 2-read/write dual-port SRAM using double pumping circuitry", 2016 IEEE ASIAN SOLID-STATE CIRCUITS CONFERENCE (A-SSCC), IEEE, 7 November 2016 (2016-11-07), pages 17 - 20, XP033061202, ISBN: 978-1-5090-3699-8, [retrieved on 20170206], DOI: 10.1109/ASSCC.2016.7844124

## Description

### Background

A dual-port memory handles two operations such as two read operations within a single clock cycle. A dual-port memory typically includes two ports operating with an array of memory cells, which may be simultaneously accessed from both ports. In order to reduce the area occupied by memory, a pseudo dual-port memory is used. The pseudo dual-port memory is designed to use a time-interleaving mechanism to perform two operations upon the single-port memory within a single clock cycle. For example, in a clock cycle, the pseudo dual-port memory may perform a first read operation, and then, perform a second read operation.

Taking two read operations of the conventional pseudo dual-port as an example, a sense amplifier is enabled twice within a single clock signal to output two reading results, respectively, and the two reading results are temporarily stored in two latches, respectively. Each latch is controlled by a corresponding control signal to output the reading result in an appropriate time. However, the control signals of the sense amplifier and the two latches may suffer a racing issue.

ISHII YUICHIRO ET AL, "A 5.92-Mb/mm2 28-nm pseudo 2-read/write dual-port SRAM using double pumping circuitry", 2016 IEEE ASIAN SOLID-STATE CIRCUITS CONFERENCE (A-SSCC), IEEE, 7 November 2019 (2016-11-07), pages 17-20, proposes pseudo dual-port (DP) SRAM by using 6T single-port (SP) SRAM bitcell with double pumping circuitry, which enables 2-read/write (2RW) operation within a clock cycle.

US 10 026 472 B2 describes, in a multi-port memory, a first pulse signal generator circuit which generates a first pulse signal following input of a clock signal. A first latch circuit sets a first start signal to a first state in response to generation of the first pulse signal, and resets the first start signal to a second state in response to a first delayed signal obtained by delaying the first start signal by a delay circuit. A second pulse signal generator circuit generates a second pulse signal following input of the first delayed signal. A first latch circuit sets a second start signal to the first state and holds this state in response to generation of the second pulse signal, and resets the second start signal to the second state in response to a second delayed signal obtained by delaying the second start signal by the delay circuit. The memory operates based on start signals.

US 2008/181040 A1 describes memory circuits capable of allowing M memory addresses of an N-port memory to be accessed concurrently, wherein N and M both are a natural number, and M is larger than N, and the M memory addresses being inputted at a first frequency, the N-port memory circuits comprising: an up-sampling logic, receiving inputs at the first frequency and generating outputs at a second frequency, for converting the M memory addresses in parallel into N sets of memory addresses in series; an N-port memory, operated at the second frequency, for sequentially receiving the N sets of memory addresses, and outputting N sets of data outputs; and a down-sampling logic, receiving the data outputs from the N-port memory at the second frequency and generating outputs at the first frequency, for serially receiving the N sets of data outputs and outputting M data outputs in parallel.

US 2009/129173 A1 describes a semiconductor integrated circuit device. The semiconductor integrated circuit device includes: a first latch which can hold an output signal of the X decoder and transfer the signal to the word driver in a post stage subsequent to the X decoder; a second latch which can hold an output signal of the Y decoder and transfer the signal to the column multiplexer in the post stage subsequent to the Y decoder; and a third latch which can hold an output signal of the sense amplifier and transfer the signal to the output buffer in the post stage subsequent to the sense amplifier.

JP 4 673008 B2 describes the provision of a semiconductor storage device which can simultaneously access different addresses using a bit cell for a single port. The semiconductor storage device is a split word line type synchronous semiconductor memory device (SRAM) having a memory array using single port bit cells, an input terminal for SRAM control, a data input terminal, and two ports 1 and 2 each having a data output terminal. A plurality of column gates corresponding to port 1 and port 2 are connected to the bit line, and each port has a sense amplifier and a write buffer, and a data input/output circuit connected to them. A block of columns including divided word lines and bit lines in word units connected thereto are selected from a common memory array at different addresses by selecting two non-identical blocks by inputting column addresses of ports 1 and 2, respectively. This document describes a pseudo dual-port memory, comprising: a single-port memory; a timing control circuit, configured to sequentially generate a first sense amplifier control signal and a second sense amplifier control signal; and an output circuit, comprising a first sense amplifier, a first latch coupled to the first sense amplifier, a second sense amplifier, and a second latch coupled to the second sense amplifier, wherein the first sense amplifier is configured to receive output data from a complementary bit line pair of the single-port memory to output a first output signal, and to amplify the first output signal according to the first sense amplifier control signal, the amplified first output signal being provided as first data to the first latch, wherein the first data stored in the first latch serves as a first reading result corresponding to the first address, the second sense amplifier is configured to receive the output data from the complementary bit line pair the single-port memory to output a second output signal, and to amplify the second output signal according to the second sense amplifier control signal, the amplified second output signal being provided as second data to the second latch, wherein the second data stored in the second latch serves as a second reading result corresponding to the second address.

### Summary

It is therefore an objective of the present invention to provide a pseudo dual-port memory, which is more robust and efficient, to solve the above-mentioned problems.

The invention is set out in the appended set of claims.

These and other objectives of the present invention will no doubt become obvious to those of ordinary skill in the art after reading the following detailed description in conjunction with the various figures and drawings.

### Brief Description of the Drawings

FIG. 1 is a diagram illustrating a pseudo dual-port memory according to one embodiment of the present invention.
FIG. 2 shows a circuit within part of the single port memory and a circuit within part of the output circuit not according to the present invention.
FIG. 3 shows the sense amplifier according to one embodiment of the present invention.
FIG. 4 shows a timing diagram of some signals shown in FIG. 2 and FIG. 3.
FIG. 5 shows a circuit within part of the single port memory and a circuit within part of the output circuit according to one embodiment of the present invention.
FIG. 6 shows a timing diagram of some signals shown in FIG. 5 and FIG. 3 according to one embodiment of the present invention.

### Detailed Description

Certain terms are used throughout the following description and claims to refer to particular system components. As one skilled in the art will appreciate, manufacturers may refer to a component by different names. This document does not intend to distinguish between components that differ in name but not function. In the following discussion and in the claims, the terms "including" and "comprising" are used in an open-ended fashion, and thus should be interpreted to mean "including, but not limited to ...". The terms "couple" and "couples" are intended to mean either an indirect or a direct electrical connection. Thus, if a first device couples to a second device, that connection may be through a direct electrical connection, or through an indirect electrical connection via other devices and connections.

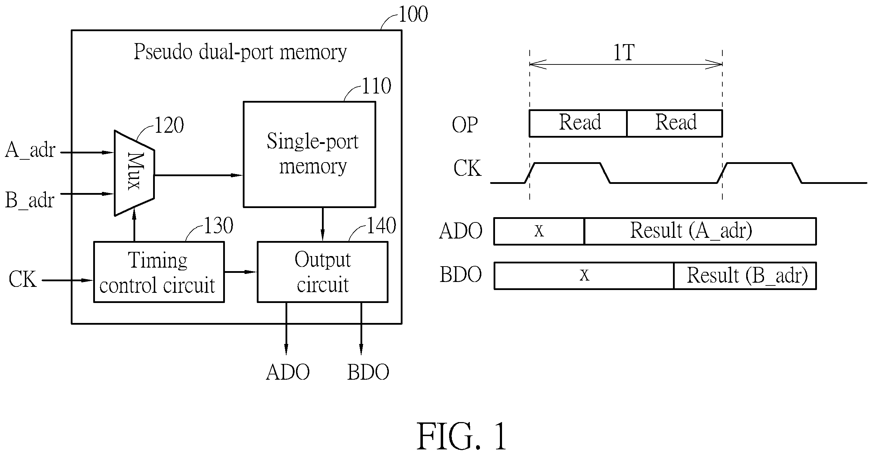

FIG. 1 is a diagram illustrating a pseudo dual-port memory 100. As shown in FIG. 1, the pseudo dual-port memory 100 comprises a single-port memory 110, a multiplexer 120, a timing control circuit 130 and an output circuit 140. The pseudo dual-port memory 100 is designed to use a time-interleaving mechanism to perform two operations upon the single-port memory 110 within a single clock cycle. For example, FIG. 1 shows that two read operations are performed within one cycle (e.g., '1T') of a clock signal CK. The pseudo dual-port memory 100 is a pseudo dual-port static random access memory (SRAM), that is the single-port memory 110 comprises a plurality of SRAM cells.

In the operation of the pseudo dual-port memory 100, the multiplexer 120 receives two addresses A_adr and B_adr, and in a first half of a clock cycle, the timing control circuit 130 generates a multiplexer control signal to control the multiplexer 120 to output the address A_adr to the single-port memory 110, for the single-port memory 110 to select one memory cell corresponding to the address A_adr to generate an output data to the output circuit 140, then the output circuit 140 outputs a reading result ADO according to the output data. Then, in a second half of the clock cycle, the timing control circuit 130 generates the multiplexer control signal to control the multiplexer 120 to output the address B_adr to the single-port memory 110, for the single-port memory 110 to select one memory cell corresponding to the address B_adr to generate an output data to the output circuit 140, then the output circuit 140 outputs a reading result BDO according to the output data. By using this time-interleaving mechanism, the pseudo dual-port memory 100 can perform two read operations within the single clock cycle to output two reading results ADO and BDO sequentially.

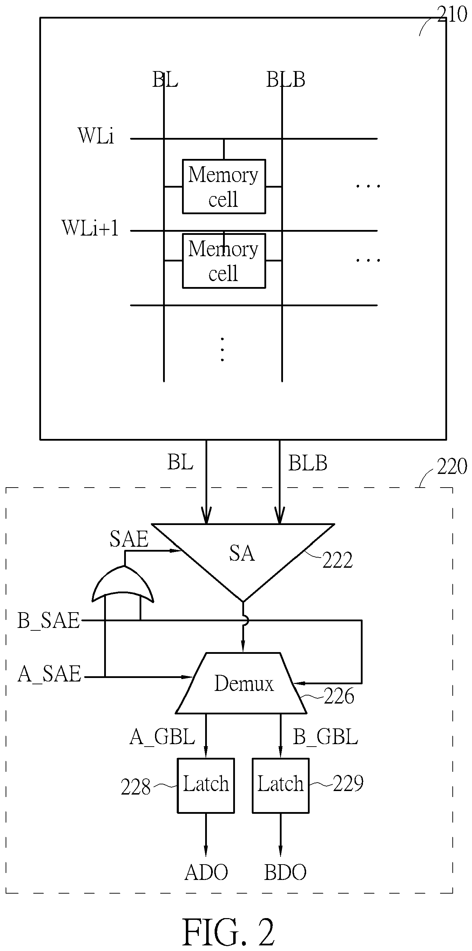

FIG. 2 shows a circuit 210 within part of the single port memory 110 and a circuit 220 within part of the output circuit 140. As shown in FIG. 2, the single-port memory 110 comprises a memory cell array, each memory cell is used to store one bit. The circuit 210 shows some memory cells belonging to a complementary bit line pair including BL and BLB, and perpendicular to the bit lines are word lines such as WLᵢ, WLᵢ₊₁. The circuit 220 within the output circuit 140 is coupled to one complementary bit line pair such as BL and BLB, and the circuit 220 is configured to get data from the bit lines BL/BLB to generate the two reading results ADO and BDO.

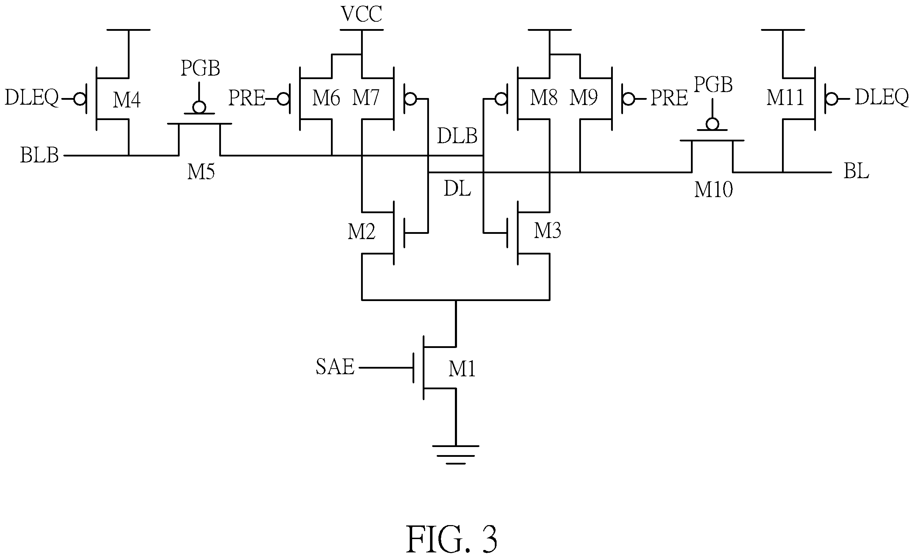

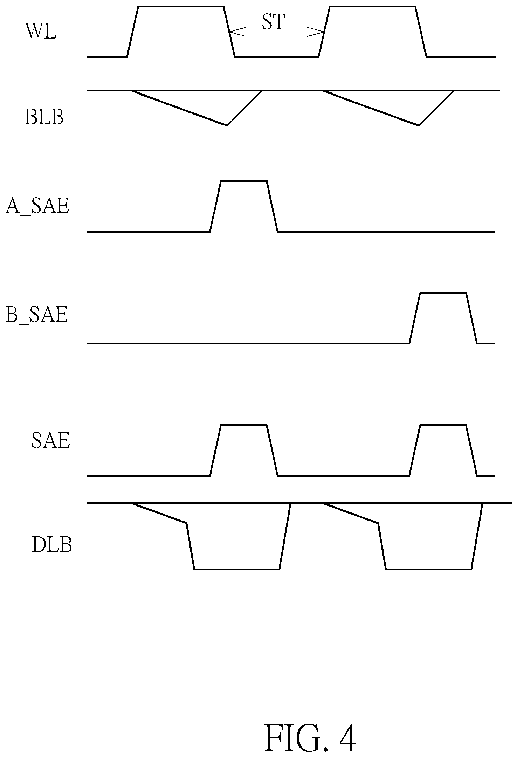

Specifically, the circuit 220 comprises a sense amplifier (SA) 222, a demultiplexer 226, an OR gate and two latches 228 and 229. FIG. 3 shows the sense amplifier 222, wherein the sense amplifier 220 comprises transistors M1 - M11, wherein the transistor M1 is controlled by a control signal SAE, the transistors M4 and M11 are controlled by a signal DLEQ, the transistors M5 and M10 are controlled by a signal PBG that indicates a read operation when set to logic low, the transistors M6 and M9 are controlled by a pre-charge signal PRE. The sense amplifier 220 is configured to receive signals from the bit lines BL and BLB to generate signals DL and DLB to the following circuit. Because the operation of the sense amplifier 220 is known by a person skilled in the art, the detailed descriptions about the transistors M1 - M11 are omitted here. FIG. 4 shows a timing diagram of some signals within the circuit 210 and the circuit 220. Referring to FIGs. 1-4 together, regarding the operation of the circuit 210 and the circuit 220, the timing control circuit 130 generates a first control signal A_SAE and a second control signal B_SAE to the circuit 220, wherein the first control signal A_SAE is used to control the circuit 220 to generate the reading result ADO corresponding to the first read operation, and the second control signal B_SAE is used to control the circuit 220 to generate the reading result BDO corresponding to the second read operation. In detail, in a first half of a clock cycle, the timing control circuit 130 generates a multiplexer control signal to control the multiplexer 120 to output the address A_adr to the single-port memory 110, and the single-port memory 110 selects one memory cell corresponding to the address A_adr to generate output data at the bit lines BL and BLB. Then, the timing control circuit 130 generates the first control signal A_SAE having the enable state, and the OR gate receives the first control signal A_SAE to generate the control signal SAE having the enable state to control the sense amplifier 222 to generate signals DL and DLB. At this time, the demultiplexer 226 is controlled by the first control signal A_SAE having the enable state to output data A_GBL (i.e., signals DL and DLB) into the latch 228, wherein the data stored in the latch 228 serves as the reading result ADO. Then, in a second half of a clock cycle, the timing control circuit 130 generates the multiplexer control signal to control the multiplexer 120 to output the address B_adr to the single-port memory 110, and the single-port memory 110 selects one memory cell corresponding to the address B_adr to generate output data at the bit lines BL and BLB. Then, the timing control circuit 130 generates the second control signal B_SAE having the enable state, and the OR gate receives the second control signal B_SAE to generate the control signal SAE having the enable state to control the sense amplifier 222 to generate signals DL and DLB. At this time, the demultiplexer 226 is controlled by the second control signal B_SAE having the enable state to output data B_GBL (i.e., signals DL and DLB) into the latch 229, wherein the data stored in the latch 229 serves as the reading result BDO.

In light of above, because only the first control signal A_SAE and the second control signal B_SAE are used to control the sense amplifier 222 and the demultiplexer 226, this new design of the circuit 220 does not have racing issue occurred in the previous design.

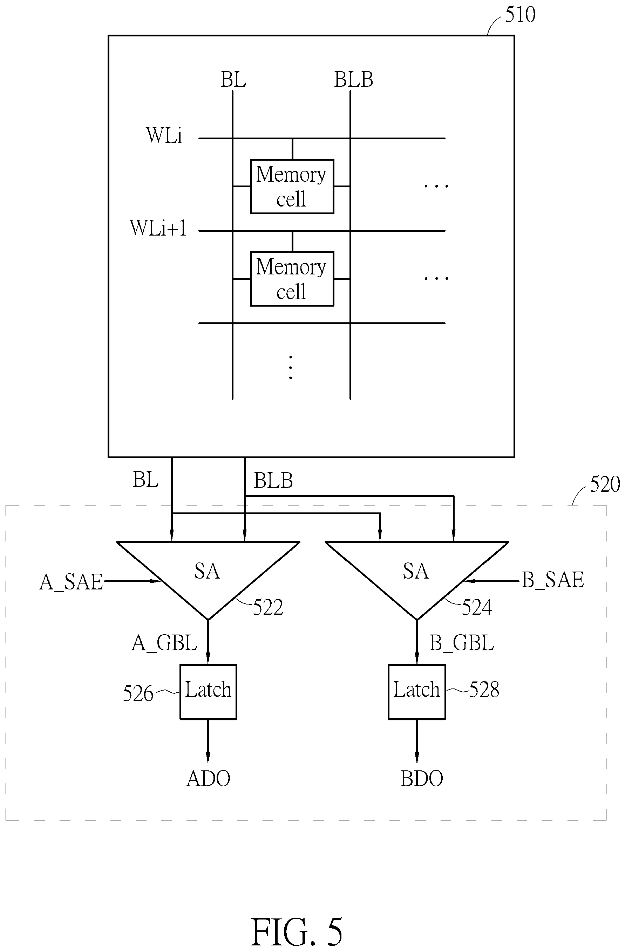

In FIG. 2, however, the timing is dominated by the pre-charging of the signal DL/DLB, so the efficiency may be influenced. Specifically, the B-port is triggered after the signal DLB is in pre-charging, so a larger setup time (i.e., 'ST' shown in FIG. 4) is required from A-port to B-port, where the A-port indicates the read operation corresponding to the first half of the clock cycle, and the B-port indicates the read operation corresponding to the second half of the clock cycle. To overcome this problem, FIG. 5 shows a circuit 510 within part of the single port memory 110 and a circuit 520 within part of the output circuit 140. As shown in FIG. 5, the single-port memory 110 comprises a memory cell array, each memory cell is used to store one bit. The circuit 510 shows some memory cells belonging to a complementary bit line pair including BL and BLB, and perpendicular to the bit lines are word lines such as WLᵢ, WLᵢ₊₁. The circuit 520 within the output circuit 140 is coupled to one complementary bit line pair such as BL and BLB, and the circuit 520 is configured to get data from the bit lines BL/BLB to generate the two reading results ADO and BDO.

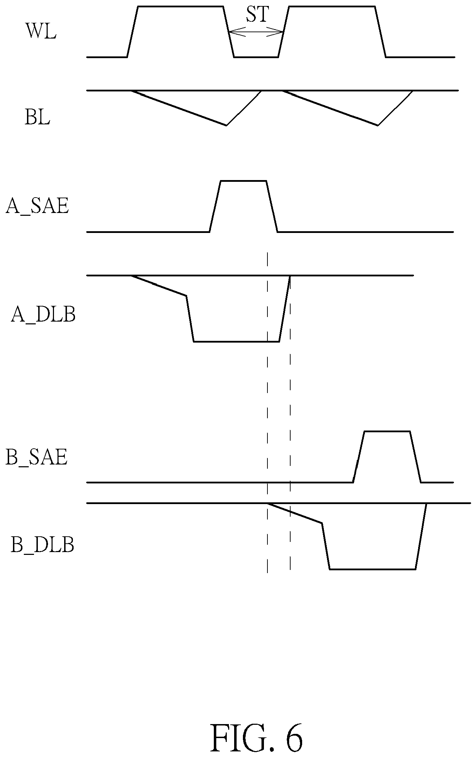

Specifically, the circuit 520 comprises two sense amplifiers 522 and 524, and two latches 526 and 528, wherein the each of the sense amplifiers 522 and 524 may have the structure shown in FIG. 3. FIG. 6 shows a timing diagram of some signals within the circuit 510 and the circuit 520. Referring to FIGs. 1, 5 and 6 together, regarding the operation of the circuit 510 and the circuit 520, in a first half of a clock cycle, the timing control circuit 130 generates a multiplexer control signal to control the multiplexer 120 to output the address A_adr to the single-port memory 110, and the single-port memory 110 selects one memory cell corresponding to the address A_adr to generate output data at the bit lines BL and BLB. Then, the timing control circuit 130 generates the first control signal A_SAE having the enable state to control the sense amplifier 522 to generate data A_GBL (i.e., the signals DL and DLB, 'A_GLB' shown in FIG. 6) to the latch 526, wherein the data stored in the latch 526 serves as the reading result ADO; meanwhile, the second control signal B_SAE does not have the enable state, so that the sense amplifier 524 does not output any valid data when the sense amplifier 522 is enabled. Then, in a second half of the clock cycle, the timing control circuit 130 generates the multiplexer control signal to control the multiplexer 120 to output the address B_adr to the single-port memory 110, and the single-port memory 110 selects one memory cell corresponding to the address B_adr to generate output data at the bit lines BL and BLB. Then, the timing control circuit 130 generates the second control signal B_SAE having the enable state to control the sense amplifier 524 to generate data B_GBL (i.e., the signals DL and DLB, 'B_GLB' shown in FIG. 6) to the latch 528, wherein the data stored in the latch 528 serves as the reading result BDO; meanwhile, the first control signal A_SAE does not have the enable state, so that the sense amplifier 522 does not output any valid data when the sense amplifier 524 is enabled.

In FIG. 5, the timing is dominated by the pre-charging of the bit lines BL/BLB, so the signal of B-port and the signal of A-port overlaps partially as shown in FIG. 6. Therefore, the setup time (i.e. 'ST' shown in FIG. 4) from A-port to B-port is small, and the circuit 520 operates in a faster speed to have better efficiency.

Briefly summazied, in the pseudo dual-port memory, the output circuit is only controlled by two control signals A_SAE and B_SAE to receive the output data from the single-port memory and output two reading results within a single clock cycle. Therefore, the pseudo dual-port memory does not suffer the racing issue between many control signals. Two sense amplifiers are designed to output two reading results separately in one clock cycle, to improve the efficiency of the pseudo dual-port memory.

## Claims

1. A pseudo dual-port memory (100), comprising:
a single-port memory (110);
a multiplexer (120), configured to receive a first address and a second address, and output one of the first address and the second address to the single-port memory (110);
a timing control circuit (130), configured to sequentially generate: a first multiplexer control signal to control the multiplexer (120) to output the first address to the single-port memory (110), a first sense amplifier control signal, a second multiplexer control signal to control the multiplexer (120) to output the second address to the single-port memory (110), and a second sense amplifier control signal; and
an output circuit (140, 520), comprising: a first sense amplifier (522), a first latch (526) coupled to the first sense amplifier (522), a second sense amplifier (524), and a second latch (528) coupled to the second sense amplifier (527), wherein
the first sense amplifier (522) is configured to receive output data from a complementary bit line pair of the single-port memory (110) to output a first output signal, and to amplify the first output signal according to the first sense amplifier control signal, the amplified first output signal being provided as first data to the first latch (526), wherein the first data stored in the first latch (526) serves as a first reading result corresponding to the first address,
the second sense amplifier (524) is configured to receive the output data from the complementary bit line pair the single-port memory (110) to output a second output signal, and to amplify the second output signal according to the second sense amplifier control signal, the amplified second output signal being provided as second data to the second latch (528), wherein the second data stored in the second latch (528) serves as a second reading result corresponding to the second address, and
wherein the pseudo dual-port memory is such that a period of provision of the second output signal and a period of provision of the amplified first output signal are partially overlapped.

2. The pseudo dual-port memory (100) of claim 1, wherein the timing control circuit (130) is configured to generate the multiplexer control signals to control the multiplexer (120) to output the first address and the second address to the single-port memory (110) within a clock cycle, and the timing control circuit (130) is further configured to generate the first sense amplifier control signal and the second sense amplifier control signal to sequentially enable the first sense amplifier (522) and the second sense amplifier (524).

3. The pseudo dual-port memory (100) of claim 2, wherein the first sense amplifier (522) is configured to provide the first data to the first latch (526) when the first sense amplifier control signal has an enable state, the second sense amplifier (524) is configured to provide the second data to the second latch (528) when the second sense amplifier control signal has the enable state, and the enable state of the first sense amplifier control signal and the enable state of the second sense amplifier control signal is within a single clock cycle.

## Patentansprüche

1. Pseudo-Dual-Port-Speicher (100), umfassend:
einen Single-Port-Speicher (110);
einen Multiplexer (120), der dazu konfiguriert ist, eine erste Adresse und eine zweite Adresse zu empfangen und eine der ersten Adresse und der zweiten Adresse an den Single-Port-Speicher (110) auszugeben;
eine Zeitsteuerschaltung (130), die dazu konfiguriert ist, sequenziell Folgendes zu erzeugen: ein erstes Multiplexer-Steuersignal, um den Multiplexer (120) zu steuern, um die erste Adresse an den Single-Port-Speicher (110) auszugeben, ein erstes Abtastverstärkersteuersignal, ein zweites Multiplexer-Steuersignal, um den Multiplexer (120) zu steuern, um die zweite Adresse an den Single-Port-Speicher (110) auszugeben, und ein zweites Abtastverstärkersteuersignal; und
eine Ausgabeschaltung (140, 520), umfassend: einen ersten Abtastverstärker (522), einen ersten Latch (526), der mit dem ersten Abtastverstärker (522) gekoppelt ist, einen zweiten Abtastverstärker (524) und einen zweiten Latch (528), der mit dem zweiten Abtastverstärker (527) gekoppelt ist, wobei
der erste Abtastverstärker (522) dazu konfiguriert ist, Ausgabedaten von einem komplementären Bitleitungspaar des Single-Port-Speichers (110) zu empfangen, um ein erstes Ausgabesignal auszugeben, und das erste Ausgabesignal gemäß dem ersten Abtastverstärkersteuersignal zu verstärken, wobei das verstärkte erste Ausgabesignal als erste Daten dem ersten Latch (526) bereitgestellt wird, wobei die in dem ersten Latch (526) gespeicherten ersten Daten als ein erstes Leseergebnis entsprechend der ersten Adresse dienen,
der zweite Abtastverstärker (524) dazu konfiguriert ist, die Ausgabedaten von dem komplementären Bitleitungspaar des Single-Port-Speichers (110) zu empfangen, um ein zweites Ausgabesignal auszugeben, und das zweite Ausgabesignal gemäß dem zweiten Abtastverstärkersteuersignal zu verstärken, wobei das verstärkte zweite Ausgabesignal als zweite Daten dem zweiten Latch (528) bereitgestellt wird, wobei die in dem zweiten Latch (528) gespeicherten zweiten Daten als ein zweites Leseergebnis entsprechend der zweiten Adresse dienen, und
wobei der Pseudo-Dual-Port-Speicher derart ist, dass sich eine Periode der Bereitstellung des zweiten Ausgangssignals und eine Periode der Bereitstellung des verstärkten ersten Ausgangssignals teilweise überlappen.

2. Pseudo-Dual-Port-Speicher (100) nach Anspruch 1, wobei die Zeitsteuerungsschaltung (130) dazu konfiguriert ist, die Multiplexer-Steuersignale zu erzeugen, um den Multiplexer (120) so zu steuern, dass er die erste Adresse und die zweite Adresse innerhalb eines Taktzyklus an den Single-Port-Speicher (110) ausgibt, und die Zeitsteuerschaltung (130) ferner dazu konfiguriert ist, das erste Abtastverstärkersteuersignal und das zweite Abtastverstärkersteuersignal zu erzeugen, um den ersten Abtastverstärker (522) und den zweiten Abtastverstärker (524) sequenziell zu aktivieren.

3. Pseudo-Dual-Port-Speicher (100) nach Anspruch 2, wobei der erste Abtastverstärker (522) dazu konfiguriert ist, die ersten Daten dem ersten Latch (526) bereitzustellen, wenn das erste Abtastverstärkersteuersignal einen Freigabezustand aufweist, der zweite Abtastverstärker (524) dazu konfiguriert ist, die zweiten Daten dem zweiten Latch (528) bereitzustellen, wenn das zweite Abtastverstärkersteuersignal den Freigabezustand aufweist, und der Freigabezustand des ersten Abtastverstärkersteuersignals und der Freigabezustand des zweiten Abtastverstärkersteuersignals innerhalb eines einzigen Taktzyklus liegen.

## Revendications

1. Pseudo-mémoire double port (100), comprenant :
une mémoire à port unique (110) ;
un multiplexeur (120), configuré pour recevoir une première adresse et une seconde adresse, et émettre l'une de la première adresse et de la seconde adresse à la mémoire à port unique (110) ;
un circuit de commande de synchronisation (130), configuré pour générer séquentiellement : un premier signal de commande de multiplexeur pour commander au multiplexeur (120) d'émettre la première adresse à la mémoire à port unique (110), un premier signal de commande d'amplificateur de détection, un second signal de commande de multiplexeur pour commander au multiplexeur (120) d'émettre la seconde adresse à la mémoire à port unique (110), et un second signal de commande d'amplificateur de détection ; et
un circuit de sortie (140, 520), comprenant : un premier amplificateur de détection (522), un premier verrou (526) couplé au premier amplificateur de détection (522), un second amplificateur de détection (524), et un second verrou (528) couplé au second amplificateur de détection (527), dans laquelle le premier amplificateur de détection (522) est configuré pour recevoir des données de sortie d'une paire de lignes de bit complémentaires de la mémoire à port unique (110) pour émettre un premier signal de sortie, et pour amplifier le premier signal de sortie selon le premier signal de commande d'amplificateur de détection, le premier signal de sortie amplifié étant fourni en tant que premières données au premier verrou (526), dans laquelle les premières données stockées dans le premier verrou (526) servent de premier résultat de lecture correspondant à la première adresse,
le second amplificateur de détection (524) est configuré pour recevoir les données de sortie de la paire de lignes de bit complémentaires de la mémoire à port unique (110) pour émettre un second signal de sortie, et pour amplifier le second signal de sortie selon le second signal de commande d'amplificateur de détection, le second signal de sortie amplifié étant fourni en tant que secondes données au second verrou (528), dans laquelle les secondes données stockées dans le second verrou (528) servent de second résultat de lecture correspondant à la seconde adresse, et
dans laquelle la pseudo-mémoire double port est telle qu'une période de fourniture du second signal de sortie et une période de fourniture du premier signal de sortie amplifié sont partiellement chevauchées.

2. Pseudo-mémoire double port (100) selon la revendication 1, dans laquelle le circuit de commande de synchronisation (130) est configuré pour générer les signaux de commande de multiplexeur pour commander au multiplexeur (120) d'émettre la première adresse et la seconde adresse à la mémoire à port unique (110) à l'intérieur d'un cycle d'horloge, et le circuit de commande de synchronisation (130) est également configuré pour générer le premier signal de commande d'amplificateur de détection et le second signal de commande d'amplificateur de détection pour activer séquentiellement le premier amplificateur de détection (522) et le second amplificateur de détection (524) .

3. Pseudo-mémoire double port (100) selon la revendication 2, dans laquelle le premier amplificateur de détection (522) est configuré pour fournir les premières données au premier verrou (526) lorsque le premier signal de commande d'amplificateur de détection présente un état d'activation, le second amplificateur de détection (524) est configuré pour fournir les secondes données au second verrou (528) lorsque le second signal de commande d'amplificateur de détection présente l'état d'activation, et l'état d'activation du premier signal de commande d'amplificateur de détection et l'état d'activation du second signal de commande d'amplificateur de détection est à l'intérieur d'un cycle d'horloge unique.
